# EUROPÄISCHE PATENTANMELDUNG

(11) **EP 0 548 479 A1**
(43) Veröffentlichungstag der Anmeldung: **30.06.1993**
(21) Anmeldenummer: 92116947.0
(22) Anmeldetag: 05.10.1992
(51) Int. Cl.: H03G 3/00, H03G 7/00

(54) **Verstärkerschaltung mit exponentieller Verstärkungssteuerung**

(30) Priorität: 21.12.1991 DE 4142539
(71) Anmelder: HAGENUK GMBH, D-24118 Kiel (DE)
(72) Erfinder: Schönke, Herbert, W-2353 Schülp/Nortorf (DE)
(74) Vertreter: Hansmann, Dierk, Dipl.-Ing.

(57) **Zusammenfassung**

Die Vorrichtung dient zur Verstärkung elektrischer Signale und weist ein Verstärkungselement (1) sowie eine Steuereinheit (7) zur Beeinflussung eines Verstärkungsfaktors auf. Die Steuereinheit ist aus mindestens einem Steuerelement (8) sowie mindestens einem Steuerwiderstand (9) ausgebildet. Das Verstärkungselement ist als stromgesteuerter Verstärker (2) ausgebildet. Das Steuerelement besteht aus einem Transistorpaar (10,11), bei dem ein Primärtransistor (10) von einer Konstantgleichstromquelle (12) gespeist ist. Ein Sekundärtransistor (11) des Transistorpaares ist mit einem Stromsteuereingang des Verstärkers verbunden. Die Basis des Sekundärtransistors ist mit dem Primärtransistors gekoppelt und im Bereich des Primärtransistors sind mindestens zwei Steuerwiderstände vorgesehen.

## Beschreibung

Die Erfindung betrifft eine Vorrichtung zur Verstärkung elektrischer Signale, die ein Verstärkungselement sowie eine Steuereinheit zur Beeinflussung eines Verstärkungsfaktors aufweist und bei der die Steuereinheit aus mindestens einem Steuerelement sowie mindestens einem Steuerwiderstand ausgebildet ist.

Bei bekannten derartigen Vorrichtungen ist das Verstärkungselement als ein invertierend betriebener Operationsverstärker ausgebildet, der im Bereich eines Gegenkopplungszweiges mit binär gestuften Widerständen versehen ist. Die Widerstände sind dabei zueinander parallel angeordnet. Jeder der Widerstände ist jeweils mit einem Transistor oder einem ähnlichen Schaltelement in Reihe geschaltet. Durch eine geeignete Ansteuerung der Transistoren können die Widerstände zugeschaltet werden. Bei einer Anordnung von sechs Widerständen kann somit durch eine geeignete Ansteuerung ein Gegenkopplungsnetzwerk aufgebaut werden, das 32 verschiedene Zustände einnehmen kann. Derartige Netzwerke können zu einem automatisierten Verstärkerabgleich, beispielsweise im Bereich von schnurlosen Telefonen, verwendet werden. Die Ansteuersignale für die Transistoren können beispielsweise Programmierschaltern oder einer Logik-Speicherschaltung entnommen werden.

Diese Anordnung weist jedoch Nachteile auf, wenn eine logarithmische Einstellung der Verstärkung erfolgen soll. Bei einer derartigen Einstellung können wegen der logarithmischen Stufung nur eine geringe Anzahl der theoretisch möglichen Kodierungseinstellungen zur Anwendung gelangen. Hierzu ist eine aufwendige Steuerlogik mit einer erhöhten Anzahl von Steuerbits erforderlich.

Aufgabe der vorliegenden Erfindung ist es daher, eine Vorrichtung der einleitend genannten Art derart zu konstruieren, daß eine logarithmische Verstärkungseinstellung in linearen Schritten erfolgen kann.

Diese Aufgabe wird erfindungsgemäß dadurch gelöst, daß das Verstärkungselement als ein stromgesteuerter Verstärker ausgebildet ist und das Steuerelement aus einem Transistorpaar besteht, bei dem ein als Diode geschalteter Primärtransistor von einer Konstantgleichstromquelle gespeist ist sowie der Kollektor des Sekundärtransistors mit dem Stromsteuereingang des Verstärkers verbunden ist, die Basis des Sekundärtransistors mit dem Primärtransistor gekoppelt ist und im Bereich des Primärtransistors mindestens zwei Steuerwiderstände vorgesehen sind.

Durch diese Schaltungsanordnung ist es möglich, mit Hilfe der Steuerwiderstände im Bereich des Zweiges des Primärtransistors relativ zu einem Bezugspotential eine Differenzspannung in linearen Schritten zu erzeugen und durch diese den Strom durch den Sekundärtransistor exponentiell zu beeinflussen, der den Verstärkungsfaktor des Operationsverstärkers festlegt. Beträgt diese Differenzspannung 0 Volt, so sind die Ströme durch den Primärtransistor und durch den Sekundärtransistor gleich. Bei einer Differenzspannung ungleich 0 Volt, die sich linear ändert, erfolgt hingegen eine exponentielle Änderung des Stromes durch den Sekundärtransistor und somit eine exponentielle Änderung des Verstärkungsfaktors.

Eine einfache Ansteuerung des Primärtransistors wird dadurch ermöglicht, daß der Primärtransistor als ein npn-Transistor ausgebildet ist und der Kollektor des Primärtransistors sowie die Basis des Primärtransistors mit der Konstantgleichstromquelle verbunden sind.

Eine genaue und dennoch schaltungstechnisch einfach zu realisierende Einstellung des Verstärkungsfaktors erfolgt dadurch, daß der Sekundärtransistor als ein npn-Transistor ausgebildet ist und der Kollektor des Sekundärtransistors eine Verbindung zum Steuereingang des Operationsverstärkers aufweist.

Zur Bereitstellung eines definierten Kollektorstromes wird vorgeschlagen, daß der Emitter des Sekundärtransistors eine Verbindung zu einem Masseanschluß aufweist.

Eine Beaufschlagung des Zweiges des Primärtransistors mit einer Differenzspannung erfolgt dadurch, daß der Emitter des Primärtransistors über einen Bezugswiderstand mit dem Masseanschluß verbunden ist.

Eine definierte Berücksichtigung der Steuerwiderstände entsprechend dem Prinzip eines Spannungsteilers erfolgt dadurch, daß die Steuerwiderstände mit einer Verbindungsleitung gekoppelt sind, die zwischen dem Emitter des Primärtransistors und dem Bezugswiderstand angeordnet ist.

Eine einfache Steuerlogik kann dadurch bereitgestellt werden, daß die Steuerwiderstände zueinander parallel geschaltet sind.

Eine in einfacher Weise digital ansteuerbare Schaltung wird dadurch bereitgestellt, daß die Steuerwiderstände binär gestufte Widerstandswerte aufweisen.

Zur Bereitstellung einer definierten Anschlußschnittstelle zur Einspeisung der Einstellsignale ist es zweckmäßig, daß die Steuerwiderstände Kodierungsanschlüsse zur Beaufschlagung mit Ansteuersignalen aufweisen.

Zur Verringerung einer maximalen Abweichung der Verstärkungscharakteristik bei einem Auftreten von Temperaturschwankungen wird vorgeschlagen, daß zwischen dem Emitter des Sekundärtransistors und dem Masseanschluß eine Hilfsspannungsquelle vorgesehen ist, die als eine Gleichspannungsquelle ausgebildet ist.

In den Zeichnungen sind Ausführungsbeispiele der Erfindung schematisch dargestellt. Es zeigen:
- Fig. 1: ein elektrisches Schaltbild der Vorrichtung,
- Fig. 2: eine Kurvenschar zur Verdeutlichung der Abhängigkeit des linearen Verlaufes der Steuerspannung und des exponentiellen Verlaufes des dem Operationsverstärker zugeführten Steuerstromes bei sich ändernden Temperaturen und
- Fig. 3: eine Kurvenschar gemäß Figur 2, bei der zur Minimierung des Temperaturfehlers im Zweig des Sekundärtransistors eine zusätzliche Hilfsspannungsquelle angeordnet ist.

Die Vorrichtung besteht im wesentlichen aus einem Verstärkungselement (1), das als ein stromgesteuerter Verstärker (2) ausgebildet ist. Der Verstärker (2) weist einen invertierenden Eingang (3), einen nichtinvertierenden Eingang (4) sowie einen Ausgang (5) auf. Darüber hinaus ist der Verstärker (2) mit einem Steuereingang (6) versehen. Zur Einstellung der Verstärkung des Verstärkers (2) ist eine Steuereinheit (7) vorgesehen, die aus einem Steuerelement (8) sowie aus Steuerwiderständen (9) ausgebildet ist. Der Verstärker (2) kann als ein Operatoinsverstärker ausgebildet werden.

Das Steuerelement (8) besteht aus einem Primärtransistor (10) und einem Sekundärtransistor (11), die zu einem Transistorpaar verschaltet sind. Beide Transistoren (10,11) sind im gezeigten Beispiel als npn-Transistoren ausgebildet. Sowohl die Basis als auch der Kollektor des Primärtransistors (10) sind mit einer Konstantgleichstromquelle (12) verbunden. Die Basis des Sekundärtransistors (11) ist an den Primärtransistor (10) angeschlossen und der Kollektor des Sekundärtransistors (11) weist eine Verbindung zum Steuereingang (6) auf.

Der Emitter des Primärtransistors (10) ist über einen Bezugswiderstand (13) mit einem Masseanschluß (14) verbunden. Darüber hinaus kann auch der Emitter des Sekundärtransistors (11) mit dem Masseanschluß (14) verbunden sein. Zur Ermöglichung einer Temperaturkompensation ist jedoch auch insbesondere daran gedacht, zwischen den Emitter des Sekundärtransistors (11) und den Masseanschluß (14) eine Hilfsspannungsquelle (11) zu schalten, die als eine Gleichspannungsquelle ausgebildet ist.

Die Steuerwiderstände (9) sind jeweils mit einem Anschluß an eine Verbindungsleitung des Emitters des Primärtransistors (10) mit dem Bezugswiderstand (13) angeschlossen. Darüber hinaus weisen die Steuerwiderstände (9) Kodierungsanschlüsse (16) auf. Insbesondere ist daran gedacht, die Steuerwiderstände (9) binär gestuft auszubilden. Dies bedeutet, daß die Widerstandswerte der einzelnen Steuerwiderstände (9) sich jeweils verdoppeln. Weist beispielsweise der Steuerwiderstand (9) mit dem geringsten Widerstand einen Widerstandswert R auf, so sind die weiteren Widerstände mit Widerstandswerten 2R, 4R etc. versehen.

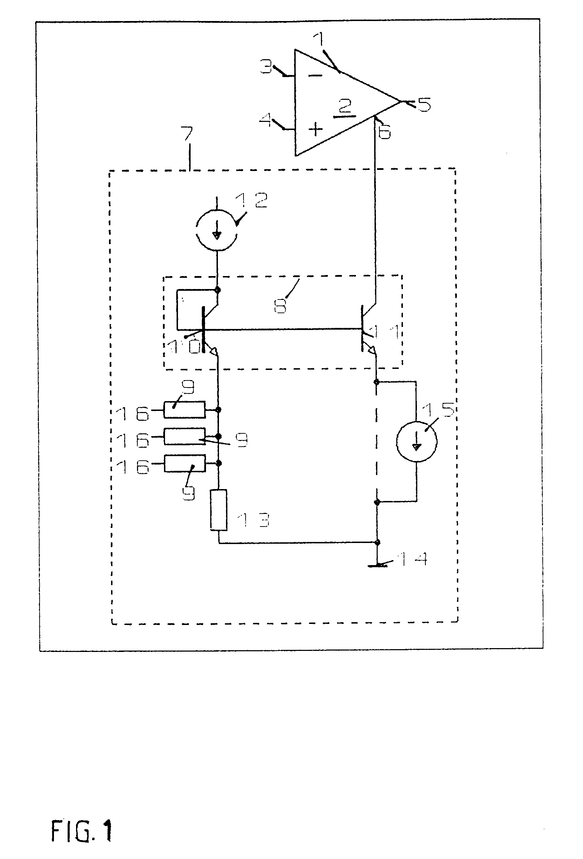

Bei einem Betrieb der in Figur 1 dargestellten Schaltung fällt am Bezugswiderstand (13) die Differenzspannung im Zweig des Primärtransistors (10) ab. Der Quotient aus dem Strom im Zweig des Primärtransistors (10) und dem Strom im Zweig des Sekundärtransistors (11) errechnet sich aus einer Potenz der Zahl "e". Die Zahl "e" wird dabei mit dem Quotienten aus dem Produkt der am Bezugswiderstand (13) abfallenden Spannung sowie einem Korrekturfaktor und dem Produkt aus einem weiteren Korrekturfaktor und der Temperatur potenziert.

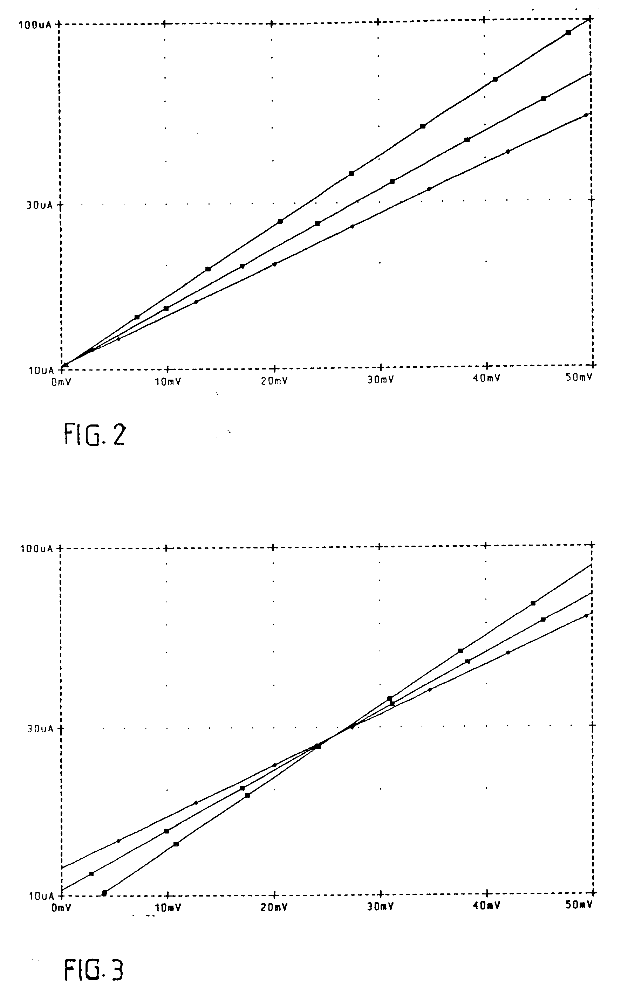

In Figur 2 ist die Abhängigkeit zwischen einer linearen Steuerspannung und dem exponentiellen Verlauf des Steuerstromes für den Verstärker (2) dargestellt. Die mittlere Kurve gibt dabei den Verlauf für eine übliche Raumtemperatur und die beiden anderen Kurven den Verlauf bei Temperaturabweichungen von der Raumtemperatur von etwa plus/minus 50 Grad Celsius wieder.

In Figur 3 ist die Abhängigkeit des Steuerstromes von der Steuerspannung dargestellt, wenn eine Hilfsspannungsquelle (15) eingesetzt wird. Hierdurch erfolgt eine Korrektur des von der Konstantgleichstromquelle (12) bereitgestellten Stromes. Bei einer üblichen Schaltungsauslegung kann die Hilfsspannungsquelle (15) mit einem Spannungswert von etwa 25 mV versehen werden.

Der maximale Temperaturfehler kann durch diese Schaltungsvariante etwa halbiert werden.

Grundsätzlich können statt der npn-Transistoren (10,11) auch pnp-Transistoren (10,11) verwendet werden. Bei der Verwendung derartig ausgebildeter gepaarter bipolarer Transistoren werden dann die jeweiligen Stromflußrichtungen umgedreht.

## Patentansprüche

1. Vorrichtung zur Verstärkung elektrischer Signale, die ein Verstärkungselement sowie eine Steuereinheit zur Beeinflussung eines Verstärkungsfaktors aufweist und bei der die Steuereinheit aus mindestens einem Steuerelement sowie mindestens einem Steuerwiderstand ausgebildet ist, dadurch gekennzeichnet, daß das Verstärkungselement (1) als ein stromgesteuerter Verstärker (2) ausgebildet ist und das Steuerelement (8) aus einem Transistorpaar besteht, bei dem ein als Diode geschalteter Primärtransistor (10) von einer Konstantgleichstromquelle (12) gespeist sowie der Kollektor des Sekundärtransistors (11) mit dem Stromsteuereingang (6) des Verstärkers (2) verbunden ist, die Basis des Sekundärtransistors (11) mit dem Primärtransistor (10) gekoppelt ist und im Bereich des Primärtransistors (10) mindestens zwei Steuerwiderstände (9) vorgesehen sind.

2. Vorrichtung nach Anspruch 1, dadurch gekennzeichnet, daß der Primärtransistor (10) als ein npn-Transistor ausgebildet ist und der Kollektor des Primärtransistors (10) sowie die Basis des Primärtransistors (10) mit der Konstantgleichstromquelle (12) verbunden sind.

3. Vorrichtung nach Anspruch 1 oder 2, dadurch gekennzeichnet, daß der Sekundärtransistor (11) als ein npn-Transistor ausgebildet ist und der Kollektor des Sekundärtransistors (11) eine Verbindung zum Steuereingang (6) des Verstärkers (2) aufweist.

4. Vorrichtung nach einem der Ansprüche 1 bis 3, dadurch gekennzeichnet, daß der Emitter des Sekundärtransistors (11) eine Verbindung zu einem Masseanschluß (14) aufweist.

5. Vorrichtung nach einem der Ansprüche 1 bis 4, dadurch gekennzeichnet, daß der Emitter des Primärtransistors (10) über einen Bezugswiderstand (13) mit dem Masseanschluß (14) verbunden ist.

6. Vorrichtung nach einem der Ansprüche 1 bis 5, dadurch gekennzeichnet, daß die Steuerwiderstände (9) mit einer Verbindungsleitung gekoppelt sind, die zwischen dem Emitter des Primärtransistors (10) und dem Bezugswiderstand (13) angeordnet ist.

7. Vorrichtung nach einem der Ansprüche 1 bis 6, dadurch gekennzeichnet, daß die Steuerwiderstände (9) zueinander parallel geschaltet sind.

8. Vorrichtung nach einem der Ansprüche 1 bis 7, dadurch gekennzeichnet, daß die Steuerwiderstände (9) binär gestufte Widerstandswerte aufweisen.

9. Vorrichtung nach einem der Ansprüche 1 bis 8, dadurch gekennzeichnet, daß die Steuerwiderstände (9) Kodierungsanschlüsse (16) zur Beaufschlagung mit Ansteuersignalen aufweisen.

10. Vorrichtung nach einem der Ansprüche 1 bis 9, dadurch gekennzeichnet, daß zwischen dem Emitter des Sekundärtransistors (11) und dem Masseanschluß (14) eine Hilfsspannungsquelle (15) vorgesehen ist, die als eine Gleichspannungsquelle ausgebildet ist.
